# EUROPEAN PATENT APPLICATION

(11) **EP 4 435 138 A1**
(43) Date of publication of application: **25.09.2024**
(21) Application number: 24164404.6
(22) Date of filing: 19.03.2024
(51) Int. Cl.: C23C 14/04, H10K 71/16

(54) **MASK ASSEMBLY AND APPARATUS FOR MANUFACTURING DISPLAY APPARATUS**

(30) Priority: 24.03.2023 KR 20230039146; 24.04.2023 KR 20230053529
(71) Applicant: Samsung Display Co., Ltd., Yongin-si, Gyeonggi-do 17113 (KR)
(72) Inventor: Hong, Seungju, 17113 Giheung-Gu, Yongin-si (KR); Lee, Jongdae, 17113 Giheung-gu, Yongin-si (KR); Park, Jongsung, 17113 Giheung-gu, Yongin-si (KR); Woo, Mina, 17113 Giheung-Gu, Yongin-si (KR); Jang, Wonyoung, 17113 Giheung-Gu, Yongin-si (KR)
(74) Representative: Dr. Weitzel & Partner

(57) **Abstract**

A mask assembly includes a mask frame including an opening area, mask sheets covering the opening area of the mask frame and arranged side by side in a first direction, and a support stick arranged between the mask frame and the mask sheets, extending in the first direction, and having ends fixed on the mask frame, wherein widths of ends of the support stick are greater than a width of a portion of the support stick that overlaps the opening area.

## Description

### CROSS-REFERENCE TO RELATED APPLICATION

### BACKGROUND

### 1. Technical Field

The present invention relates to a mask assembly and a method of manufacturing a display apparatus, and more particularly, to a mask assembly having improved alignment and a method of manufacturing a display apparatus.

### 2. Description of the Related Art

Recently, electronic devices have become widely used. Electronic devices have been used in a variety of ways, such as mobile electronic devices and fixed electronic devices, and in order to support various functions, such an electronic device includes a display apparatus capable of providing a user with visual information, such as images or video.

The display apparatus is an apparatus that visually displays data, and is formed by depositing various layers, such as an organic layer and a metal layer. A deposition material may be deposited to form a plurality of layers of the display apparatus. That is, the deposition material is sprayed from a deposition source and is deposited on a substrate through a mask assembly. In this regard, when a mask sheet, a mask frame on which the mask sheet is welded, and sticks between the mask sheet and the mask frame are deformed, the deposition material fails to be deposited at a required position on the substrate, thus degrading deposition quality.

The above-described background art is technical information possessed by the inventor in order to contrive the invention or acquired in the process of contriving the invention, and is not necessarily known art disclosed to the general public prior to the filing of the present application.

### SUMMARY

The invention is defined by the independent claims. One or more embodiments include a mask assembly in which deposition quality may be improved by improving alignment, and an apparatus for manufacturing a display apparatus, the apparatus including the mask assembly.

However, this technical problem is an example, and technical problems to be solved by one or more embodiments are not limited thereto.

Additional aspects will be set forth in part in the description which follows and, in part, will be apparent from the description, or may be learned by practice of the presented embodiments of the invention.

According to a first aspect of the invention, a mask assembly includes a mask frame including an opening area, a plurality of mask sheets covering the opening area of the mask frame and arranged side by side in a first direction, and a support stick arranged between the mask frame and the plurality of mask sheets, extending in the first direction, and having ends fixed on the mask frame, wherein withs of ends of the support stick are greater than a width of a portion of the support stick that overlaps the opening area.

The widths of the ends of the support stick may be tapered such that the widths of the ends of the support stick increase towards the ends of the support stick.

The support stick may include a support portion to support the plurality of mask sheets, a clamping portion arranged at a side of the support portion and clamped to tension the support stick, a welding portion arranged between the support portion and the clamping portion and welded on the mask frame, and a correction welding portion arranged between the support portion and the welding portion, wherein widths of the correction welding portion and the welding portion may be greater than a width of the support portion. The support stick may be a elongated stick.

The correction welding portion, the welding portion, and the clamping portion may be tapered to each have a width that increases towards the ends of the support stick.

Taper angles of the correction welding portion, the welding portion, and the clamping portion may be substantially equal to one another.

Sides of the correction welding portion, the welding portion, and the clamping portion may be symmetrical with respect to a center line of the width and be concavely tapered.

Sides of the correction welding portion, the welding portion, and the clamping portion may be symmetrical with respect to respective center lines of the widths of the correction welding portion, the welding portion, and the clamping portion and be convexly tapered.

The correction welding portion and the welding portion may be tapered to each have a width that increases towards the ends of the support stick, and the clamping portion may have a constant width.

A width of a portion of the welding portion that is connected to the clamping portion may be about 2 or more times and about 2.5 or less times the width of the support portion.

The mask assembly may further include a shield stick extending in a second direction intersecting the first direction to shield a gap between the plurality of mask sheets.

According to another aspect of the present invention, an apparatus for manufacturing a display apparatus includes a mask assembly facing a display substrate, and a deposition source facing the mask assembly at a side opposite to the display substrate, wherein the mask assembly includes a mask frame including an opening area, a plurality of mask sheets covering the opening area of the mask frame and arranged side by side in a first direction, and a support stick arranged between the mask frame and the plurality of mask sheets, extending in the first direction, and having ends fixed on the mask frame, wherein widths of the ends of the support stick are greater than a width of a portion of the support stick that overlaps the opening area.

The widths of the ends of the support stick may be tapered such that the widths of the ends of the support stick increase towards the ends of the support stick.

The support stick may include a support portion to support the plurality of mask sheets, a clamping portion arranged at a side of the support portion and clamped to tension the support stick, a welding portion arranged between the support portion and the clamping portion and welded on the mask frame, and a correction welding portion arranged between the support portion and the welding portion, wherein widths of the correction welding portion and the welding portion may be greater than a width of the support portion.

The correction welding portion, the welding portion, and the clamping portion may be tapered to each have a width that increases towards the ends of the support stick.

Taper angles of the correction welding portion, the welding portion, and the clamping portion may be substantially equal to one another.

Sides of the correction welding portion, the welding portion, and the clamping portion may be symmetrical with respect to respective center lines of widths of the correction welding portion, the welding portion, and the clamping portion and be concavely tapered.

Sides of the correction welding portion, the welding portion, and the clamping portion may be symmetrical with respect to respective center lines of widths of the correction welding portion, the welding portion, and the clamping portion and be convexly tapered.

The correction welding portion and the welding portion may be tapered to each have a width that increases towards the ends of the support stick, and the clamping portion may have a constant width.

A width of a portion of the welding portion that is connected to the clamping portion may be about 2 or more times and about 2.5 or less times the width of the support portion.

The mask assembly may further include a shield stick extending in a second direction intersecting the first direction to shield a gap between the plurality of mask sheets.

According to the inventive mask assembly and apparatus for manufacturing a display apparatus, widths of a correction welding portion and a welding portion may increase to be tapered so that it may be easy to perform correction welding on an elongated stick, also called as support stick. Accordingly, an area for correction welding may be secured to easily adjust the degree of bending even at a narrow support stick.

### BRIEF DESCRIPTION OF THE DRAWINGS

The above and other aspects, features, and advantages of certain embodiments of the invention will be more apparent from the following description taken in conjunction with the accompanying drawings, in which:
FIG. 1 is a schematic cross-sectional view of an apparatus for manufacturing a display apparatus, according to an embodiment;
FIG. 2 is a schematic perspective view of a mask assembly according to an embodiment;
FIG. 3 is a schematic plan view of a mask assembly according to an embodiment and may correspond to a region III of FIG. 2;
FIG. 4 is a schematic diagram for describing the principle of correction welding;
FIGS. 5 to 9 are schematic plan views of a mask assembly according to other embodiments;
FIG. 10 is a schematic plan view of a display apparatus manufactured using an apparatus for manufacturing a display apparatus, according to an embodiment; and
FIG. 11 is a schematic cross-sectional view of a display apparatus manufactured by an apparatus for manufacturing a display apparatus, according to an embodiment, and may correspond to a cross-section of the display apparatus taken along a line XI-XI' of FIG. 10.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the embodiments may have different forms and should not be construed as being limited to the descriptions set forth herein. Accordingly, the embodiments are merely described below, by referring to the figures, to explain aspects of the present description.

The term "and/or" includes all combinations of one or more of which associated configurations may define. For example, "A and/or B" may be understood to mean "A, B, or A and B. "

For the purposes of this invention, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z.

As the description allows for various changes and numerous embodiments, certain embodiments will be illustrated in the drawings and described in the written description. Effects and features of one or more embodiments and methods of accomplishing the same will become apparent from the following detailed description of the one or more embodiments, taken in conjunction with the accompanying drawings. However, the embodiments may have different forms and should not be construed as being limited to the descriptions set forth herein.

One or more embodiments will be described below in more detail with reference to the accompanying drawings. Those elements that are the same or are in correspondence with each other are rendered the same reference numeral regardless of the figure number, and redundant descriptions thereof are omitted.

While such terms as "first" and "second" may be used to describe various elements, such elements must not be limited to the above terms. The above terms are used only to distinguish one element from another.

The singular forms such as "a" and "an" as used herein are intended to include the plural forms as well unless the context clearly indicates otherwise.

It will be understood that the terms "include," "comprise," and "have" as used herein specify the presence of stated features or elements but do not preclude the addition of one or more other features or elements.

It will be further understood that, when a layer, region, or element is referred to as being on another layer, region, or element, it may be directly or indirectly on the other layer, region, or element. That is, for example, intervening layers, regions, or elements may or may not be present.

Sizes of elements in the drawings may be exaggerated or reduced for convenience of explanation. For example, since sizes and thicknesses of elements in the drawings are arbitrarily illustrated for convenience of explanation, the following embodiments are not limited thereto.

The x-axis, the y-axis, and the z-axis are not limited to three axes of the rectangular coordinate system and may be interpreted in a broader sense. For example, the x-axis, the y-axis, and the z-axis may be perpendicular to one another or may represent different directions that are not perpendicular to one another.

In case that an embodiment may be implemented differently, a certain process order may be performed differently from the described order. For example, two consecutively described processes may be performed substantially at the same time or performed in an order opposite to the described order.

When an element is referred to as being "on," "connected to," or "coupled to" another element, it may be directly on, connected to, or coupled to the other element or intervening elements or layers may be present. When, however, an element is referred to as being "directly on," "directly connected to," or "directly coupled to" another element, there are no intervening elements or layers present. To this end, the term "connected" may refer to physical, electrical, and/or fluid connection, with or without intervening elements. It may also be understood that if one part and another part are connected, they may or may not be integral with each other.

The term "about" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied herein, all terms (including technical and scientific terms) used herein have the same meaning as commonly understood by those skilled in the art to which this invention pertains. It will be further understood that terms, such as those defined in commonly used dictionaries, should be interpreted as having a meaning that is consistent with their meaning in the context of the relevant art and the invention, and should not be interpreted in an ideal or excessively formal sense unless clearly so defined herein.

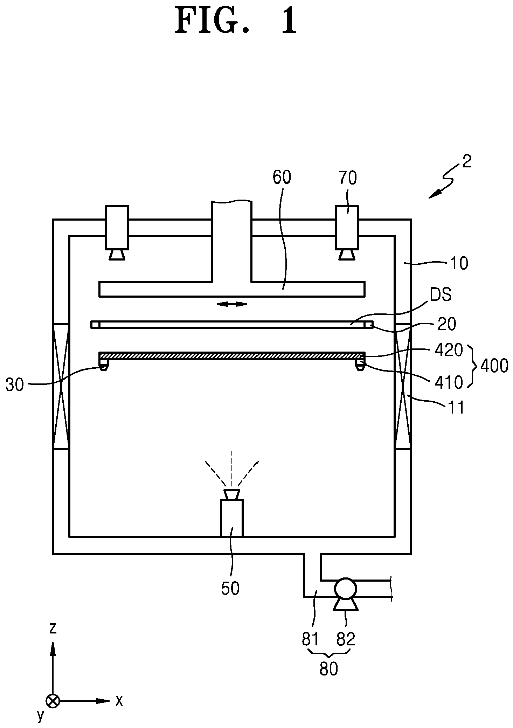

FIG. 1 is a schematic cross-sectional view of an apparatus 2 for manufacturing a display apparatus, according to an embodiment.

The apparatus 2 may include a chamber 10, a first support portion 20, a second support portion 30, a mask assembly 400, a deposition source 50, a magnetic force portion 60, a vision portion 70, and/or a pressure adjustor 80.

The chamber 10 may have a space therein and may accommodate a display substrate DS and the mask assembly 400. A portion of the chamber 10 may be opened, and a gate valve 11 may be provided in the opened portion of the chamber 10. The opened portion of the chamber 10 may be opened or closed according to the operation of the gate valve 11.

The display substrate DS may refer to the display substrate DS being in the process of manufacturing a display apparatus, in which at least one of an organic layer, an inorganic layer, and a metal layer is deposited on a substrate 100 described below. As another example, the display substrate DS may be the substrate 100 on which none of an organic layer, an inorganic layer, and a metal layer has been deposited yet.

The first support portion 20 may support the display substrate DS. The first support portion 20 may be in the form of a plate fixed inside the chamber 10. In another embodiment, the first support portion 20 may be in the form of a shuttle on which the display substrate DS is seated and which is linearly moveable in the chamber 10. In another embodiment, the first support portion 20 may include a holder, e.g., an electrostatic chuck or an adhesive chuck arranged in the chamber 10 to be fixed to the chamber 10 or movable in the chamber 10.

The second support portion 30 may support the mask assembly 400. The second support portion 30 may be arranged inside the chamber 10. The second support portion 30 may adjust (or fine-adjust) a position of the mask assembly 400. The second support portion 30 may include a separate driver or alignment unit for moving the mask assembly 400 in different directions.

In another embodiment, the second support portion 30 may be in the form of a shuttle. The second support portion 30 may have the mask assembly 400 seated thereon and may transport the mask assembly 400. For example, the second support portion 30 may move out of the chamber 10, the mask assembly 400 may be seated on the second support portion 30, and the second support portion 30 may enter the chamber 10 from outside the chamber 10.

The first support portion 20 and the second support portion 30 may be integral with each other. The first support portion 20 and the second support portion 30 may include a movable shuttle. The first support portion 20 and the second support portion 30 may include a structure of fixing the mask assembly 400 and the display substrate DS to each other with the display substrate DS seated on the mask assembly 400, and may linearly move the display substrate DS and the mask assembly 400 simultaneously.

However, hereinafter, a form in which the first support portion 20 and the second support portion 30 are separate from each other and arranged at different positions and a form in which the first support portion 20 and the second support portion 30 are arranged inside the chamber 10 will be mainly described in detail for convenience.

The deposition source 50 may face the mask assembly 400. A deposition material may be accommodated in the deposition source 50, and the deposition material may be evaporated or sublimated by applying heat to the deposition material. The deposition source 50 may be fixed inside the chamber 10 or may be arranged inside the chamber 10 to be linearly moveable in a direction.

The mask assembly 400 may be arranged inside the chamber 10. The mask assembly 400 may include a mask frame 410 and a mask sheet 420. This will be described below in more detail. A deposition material may pass through the mask assembly 400 and be deposited on the display substrate DS.

The magnetic force portion 60 may be arranged inside the chamber 10 to face the display substrate DS and/or the mask assembly 400. The magnetic force portion 60 may apply force to the mask assembly 400 towards the display substrate DS by applying magnetic force to the mask assembly 400. The magnetic force portion 60 may prevent the mask sheet 420 from sagging down and may also cause the mask sheet 420 to be adjacent to the display substrate DS. The magnetic force portion 60 may uniformly maintain an interval between the mask sheet 420 and the display substrate DS.

The vision portion 70 may be arranged in the chamber 10 and may capture images of positions of the display substrate DS and the mask assembly 400. The vision portion 70 may include a camera for capturing images of the display substrate DS and the mask assembly 400. Based on the images captured by the vision portion 70, positions of the display substrate DS and the mask assembly 400 may be identified, and deformation of the mask assembly 400 may be checked for. Based on the images, the position of the display substrate DS may be adjusted by the first support portion 20, or the position of the mask assembly 400 may be adjusted by the second support portion 30. However, hereinafter, a case where a position of the mask assembly 400 is adjusted by the second support portion 30 to align positions of the display substrate DS and the mask assembly 400 with each other will be mainly described in detail.

The pressure adjustor 80 may be connected to the chamber 10 to adjust internal pressure of the chamber 10. For example, the pressure adjustor 80 may adjust internal pressure of the chamber 10 to a level that is the same as or similar to that of atmospheric pressure. The pressure adjustor 80 may adjust internal pressure of the chamber 10 to a level that is the same as or similar to that of a vacuum state.

The pressure adjustor 80 may include a connection pipe 81 connected to the chamber 10 and a pump 82 provided on the connection pipe 81. In this regard, external air may be introduced through the connection pipe 81 or gas inside the chamber 10 may be guided to the outside through the connection pipe 81 according to an operation of the pump 82.

According to a method of manufacturing a display apparatus (not shown) by using the apparatus 2 described above, the display substrate DS may be prepared first.

The pressure adjustor 80 may maintain internal pressure of the chamber 10 at a level that is the same as or similar to atmospheric pressure, and the gate valve 11 may open the opened portion of the chamber 10.

After that, the display substrate DS may be inserted into the chamber 10 from the outside of the chamber 10. The display substrate DS may be inserted into the chamber 10 in various ways. For example, the display substrate DS may be inserted into the chamber 10 from the outside of the chamber 10 through a robot arm or the like arranged outside the chamber 10. In another embodiment, in case that the first support portion 20 is in the form of a shuttle, after the first support portion 20 is carried out from the inside of the chamber 10 to the outside of the chamber 10, the display substrate DS may be seated on the first support portion 20 through a separate robot arm or the like arranged outside the chamber 10, and the first support portion 20 may be inserted into the chamber 10 from the outside of the chamber 10.

As described above, the mask assembly 400 may be arranged inside the chamber 10. In another embodiment, in the same or similar manner to the display substrate DS, the mask assembly 400 may be inserted into the chamber 10 from the outside of the chamber 10.

In case that the display substrate DS is inserted into the chamber 10, the display substrate DS may be seated on the first support portion 20. The vision portion 70 may capture images of positions of the display substrate DS and the mask assembly 400. The positions of the display substrate DS and the mask assembly 400 may be identified based on the images captured by the vision portion 70. The apparatus 2 may be provided with a separate controller (not shown) to identify the positions of the display substrate DS and the mask assembly 400.

In case that positions of the display substrate DS and the mask assembly 400 have been identified, the second support portion 30 may fine-adjust the position of the mask assembly 400.

After that, the deposition source 50 may operate to supply a deposition material towards the mask assembly 400, and the deposition material having passed through pattern holes in the mask sheet 420 may be deposited on the display substrate DS. The deposition source 50 may move parallel to the display substrate DS and the mask assembly 400, or the display substrate DS and the mask assembly 400 may move parallel to the deposition source 50. For example, the deposition source 50 may move relative to the display substrate DS and the mask assembly 400. The pump 82 may suck in gas inside the chamber 10 and discharge the gas to the outside, thereby maintaining the internal pressure of the chamber 10 at a level that is the same as or similar to that of a vacuum state.

The deposition material supplied from the deposition source 50 as described above may pass through the mask assembly 400 and be deposited on the display substrate DS, and accordingly, layers which are stacked each other in a display apparatus described below, for example, at least one of an organic layer, an inorganic layer, and a metal layer, may be formed.

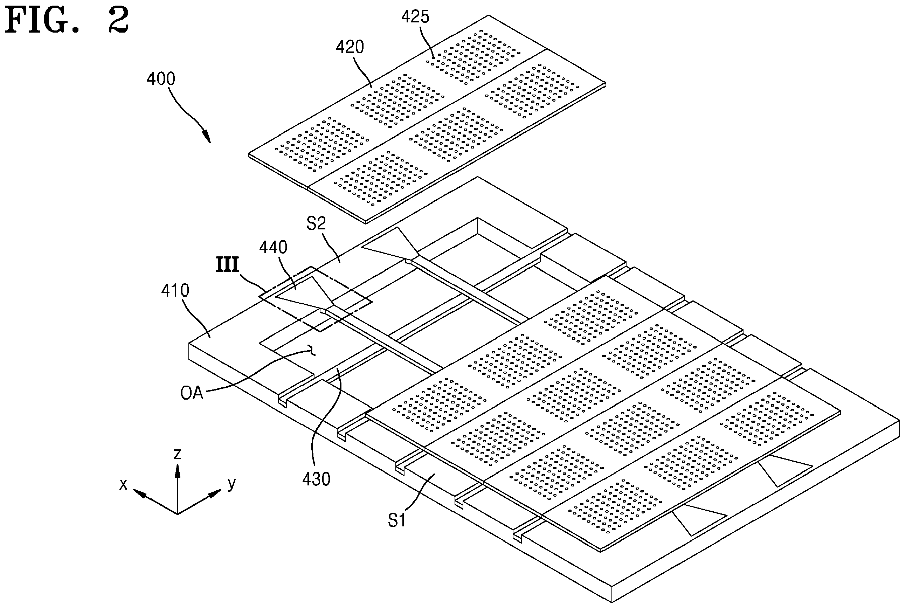

FIG. 2 is a schematic perspective view of the mask assembly 400 according to an embodiment and illustrates a mask assembly that may be used in the above-described apparatus for manufacturing a display apparatus.

Referring to FIG. 2, the mask assembly 400 may include the mask frame 410, the mask sheet 420, a shield stick 430, and/or a support stick 440. The support stick 440 may be an elongated stick having a length of at least two times a width of a mask sheet 420.

The mask frame 410 may have sides connected to each other and may include an opening area OA defined by the sides. For example, the opening area OA may be surrounded by the sides and may pass through the center of the mask frame 410.

In an embodiment, the mask frame 410 may be a quadrangular frame. However, a shape of the mask frame 410 is not limited thereto, and the mask frame 410 may have various shapes including polygonal shapes. Hereinafter, a case where the mask frame 410 is a quadrangular frame will be mainly described for convenience.

In case that the mask frame 410 is a quadrangular frame, the sides may include a first side S1 extending in a first direction (e.g., a direction x of FIG. 2) and a second side S2 extending in a second direction (e.g., a direction y of FIG. 2) intersecting the first direction. The first side S1 may include a pair of first sides S1 facing each other, the second side S2 may include a pair of second sides S2 facing each other, and the pair of first sides S1 and the pair of second sides S2 may be connected to each other. In an embodiment, the first side S1 may be a long side, and the second side S2 may be a short side. However, one or more embodiments are not limited thereto. The first side S1 may be a short side and the second side S2 may be a long side, or lengths of the first side S1 and the second side S2 may be the same as each other. Hereinafter, a case where the first side S1 is a long side and the second side S2 is a short side will be mainly described for convenience.

The mask sheet 420 may be provided on the mask frame 410 in a tensioned state. The opening area OA at the center of the mask frame 410 may be covered by the mask sheet 420. In an embodiment, the mask sheet 420 may include at least one mask sheet 420, and in case that the mask sheet 420 includes two or more mask sheets 420, the mask sheets 420 may be disposed on the mask frame 410 side by side. For example, the mask sheets 420 may be arranged side by side in the first direction (e.g., the direction x of FIG. 2). Each of the mask sheets 420 may have a shape extending long in the second direction (e.g., the direction y of FIG. 2). Ends (or both ends) of the mask sheet 420 may be fixed on the mask frame 410, for example, via welding.

The mask sheet 420 may include at least one pattern hole 425. The pattern hole 425 may be a through hole formed to allow a deposition material to pass through the mask sheet 420. The deposition material having passed through the mask sheet 420 may be deposited on the display substrate DS.

The shield stick 430 may be disposed between the mask frame 410 and the mask sheet 420 to shield a gap between mask sheets 420. In an embodiment, the shield stick 430 may include shield sticks 430, and the shield sticks 430 may be spaced apart in the first direction and arranged parallel to each other. The shield stick 430 may extend in the second direction (e.g., the direction y of FIG. 2) to cross the inside of the mask frame 410, e.g., the opening area OA. The mask frame 410 may include grooves for receiving ends of the shield stick 430. The shield stick 430 may be arranged in the grooves of the mask frame 410, and may be positioned between the mask sheets 420 to shield a gap between two adjacent mask sheets 420 to prevent a deposition material from passing therethrough.

The support stick 440 may extend in the first direction (e.g., the direction x of FIG. 2) to cross (or intersect) the inside of the mask frame 410, e.g., the opening area OA. In an embodiment, the support stick 440 may include support sticks 440, and the support sticks 440 may be spaced apart in the second direction (e.g., the direction y of FIG. 2) and arranged parallel to each other. The support stick 440 may cross the shield stick 430 in the opening area OA and may be positioned on the shield stick 430. The mask frame 410 may include grooves for receiving ends of the support stick 440, but one or more embodiments are not limited thereto. The support stick 440 may prevent the mask sheet 420 from sagging down by supporting the mask sheet 420 in the opening area OA.

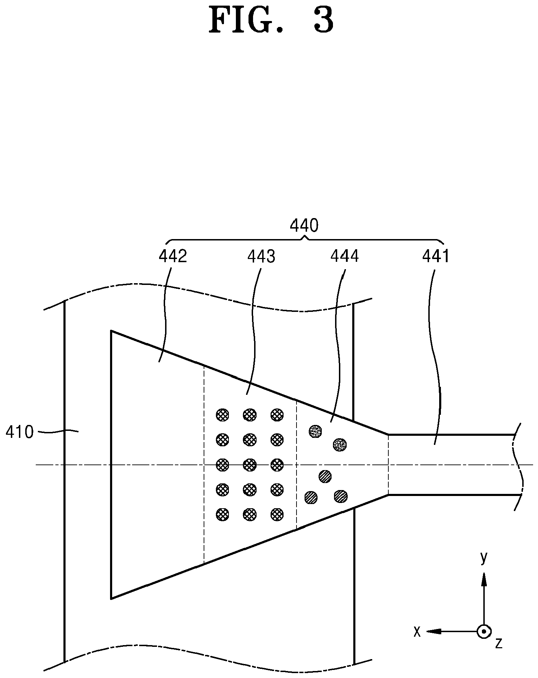

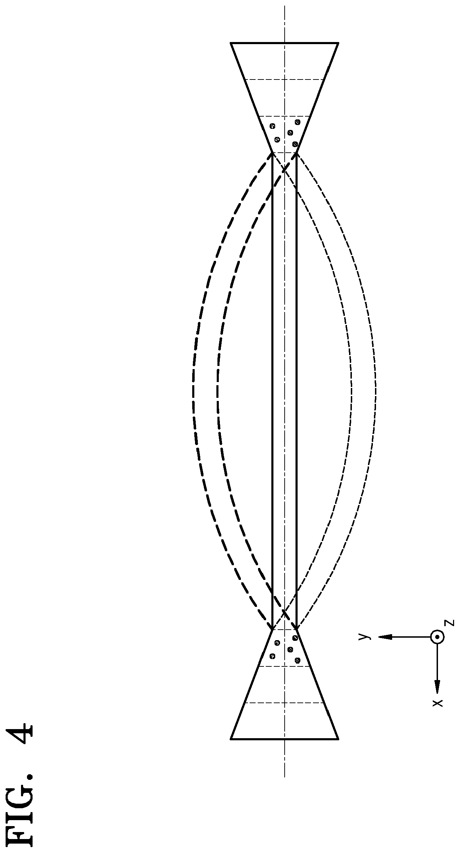

FIG. 3 is a schematic plan view of a mask assembly according to an embodiment and may correspond to region III of FIG. 2. FIG. 3 does not illustrate the mask sheet 420 for convenience of description, and the support stick 440 will be mainly described. FIG. 4 is a schematic diagram for describing the principle of correction welding.

Referring to FIG. 3, the support stick 440 may include a support portion 441, a clamping portion 442, a welding portion 443, and/or a correction welding portion 444. The clamping portion 442 may be an end portion of the support stick.

The support portion 441, which is a portion crossing the opening area OA, may be a portion that supports the mask sheet 420. The support portion 441 may be an elongated portion. For example, the support portion 441 may overlap the opening area OA of the mask frame 410 in a plan view. As described above, the support portion 441 may cross the mask sheet 420 and the shield stick 430 extending in a second direction and extend in a first direction (e.g., a direction x of FIG. 3). A width of the support portion 441 may be uniform.

The clamping portion 442 may be an area gripped by a clamping device (not shown) to tension and weld the support stick 440. Clamping portions 442 may be positioned at ends of the support portion 441 in a longitudinal direction and may be positioned on the mask frame 410 in a plan view. In an embodiment, the clamping portion 442 may be wider than the support portion 441. This may increase an area that may be gripped by the clamping device, thereby more readily gripping the support stick 440.

The welding portion 443 may be a portion welded to fix the support stick 440 to the mask frame 410. The welding portion 443 may be arranged between the support portion 441 and each of the clamping portions 442 positioned at ends of the support portion 441. Hereinafter, an end of the support stick 440 on a side (e.g., an x-direction side of FIG. 3) will be mainly described as illustrated in FIG. 3. The support stick 440 may be fixed on the mask frame 410 by performing spot welding on the welding portion 443 with the clamping portion 442 gripped and tensioned by the clamping device. Accordingly, welds may be formed on the welding portion 443. In an embodiment, the welds may be symmetrical to each other with respect to a center line of a width of the welding portion 443.

The correction welding portion 444 may be arranged between the support portion 441 and each of welding portions 443 positioned at ends (or both ends) of the support portion 441. Hereinafter, an end of the support stick 440 on one side (e.g., the x-direction side of FIG. 3) will be mainly described as illustrated in FIG. 3. The correction welding portion 444 may be used to adjust the degree of bending of the support stick 440 after fixing the support stick 440 to the mask frame 410 by performing spot welding on the welding portion 443. As shown in FIG. 4, in case that correction welding is performed on one side (e.g., a +y direction side of FIG. 4) based on a center line of a width of the correction welding portion 444, the support stick 440 may be convex towards one side (e.g., the +y direction side of FIG. 4) based on the center line of the width of the correction welding portion 444. In case that correction welding is performed on the other side (e.g., a -y direction side of FIG. 4) based on a center line of a width of the correction welding portion 444, the support stick 440 may be convex towards the other side (e.g., the -y direction side of FIG. 4) based on the center line of the width of the correction welding portion 444. By using this, the degree of bending of the support stick 440 may be corrected. Accordingly, welds may also be formed on the correction welding portion 444. In an embodiment, the welds may be asymmetrical with respect to the center line of the width of the correction welding portion 444.

The clamping portion 442, welding portion 443, and correction welding portion 444 together may form a trapezoid or a cone, in particular as opposite end portions of the support stick 440.

Referring again to FIG. 3, in an embodiment, the widths of the correction welding portion 444 and the welding portion 443 may be greater than the width of the support portion 441. For example, the correction welding portion 444, the welding portion 443, and the clamping portion 442 may be integral with one another and tapered to have a width that increases towards the end of the support stick 440. In other words, the width may increase in a direction from the correction welding portion 444 to the clamping portion 442. In an embodiment, the correction welding portion 444, the welding portion 443, and the clamping portion 442 may have a same taper angle, and the taper angle may be constant.

In an embodiment, a portion of the correction welding portion 444 that starts to be tapered as shown in FIG. 3 may overlap the opening area OA. A weld may not be formed on a portion of the correction welding portion 444 that overlaps the opening area OA, for example, a portion of the correction welding portion 444 that is not positioned on the mask frame 410. However, one or more embodiments are not limited thereto, and it will be understood that the correction welding portion 444 may be positioned on the mask frame 410 without overlapping the opening area OA and may be tapered from an inner surface towards an outer surface of the mask frame 410.

As the width of the welding portion 443 is tapered as described above, a larger area for welding the support stick 440 to the mask frame 410 may be secured. More welds may be formed on the welding portion 443, and the support stick 440 may be more firmly fixed on the mask frame 410.

As the width of the correction welding portion 444 is tapered, the degree of bending of the support stick 440 may be readily corrected. In general, the support stick 440 is narrow, and thus, a sufficient area for correction welding may not be secured. According to one or more embodiments, as the correction welding portion 444 and the welding portion 443 have a width that gradually increases from the support portion 441, an area for welding and an area for correction welding may be more secured. In an embodiment, a portion of the welding portion 443 that has the maximum width, for example, a portion of the welding portion 443 that is connected to the clamping portion 442, may be about 2 times or more and about 2.5 times or less, for example, about 2.5 times, the width of the support portion 441. In case that the welding portion 443 is about 2.5 times wider than the support portion 441, the degree of bending of the support stick 440 may be reduced in case that a weld is welded, compared to a case where the welding portion 443 (and the correction welding portion 444) are wide as much as the support portion 441. For example, in a case where the welding portion 443, the correction welding portion 444, and the support portion 441 have a same width, the degree of bending of the support stick 440 may be about 1 in case that a weld is correction welded on the correction welding portion 444. In case that a portion of the welding portion 443 that has the maximum width is about 2.5 times wider than the support portion 441, the degree of bending of the support stick 440 may be about 0.2 in case that a weld is correction welded on the correction welding portion 444. For example, as the widths of the welding portion 443 and the correction welding portion 444 increase, the degree of bending resulting from correction welding may be about 1/5. Accordingly, the degree of bending of the support stick 440 may be more precisely corrected, and correction welding may be performed multiple times because an area of the correction welding portion 444 is secured.

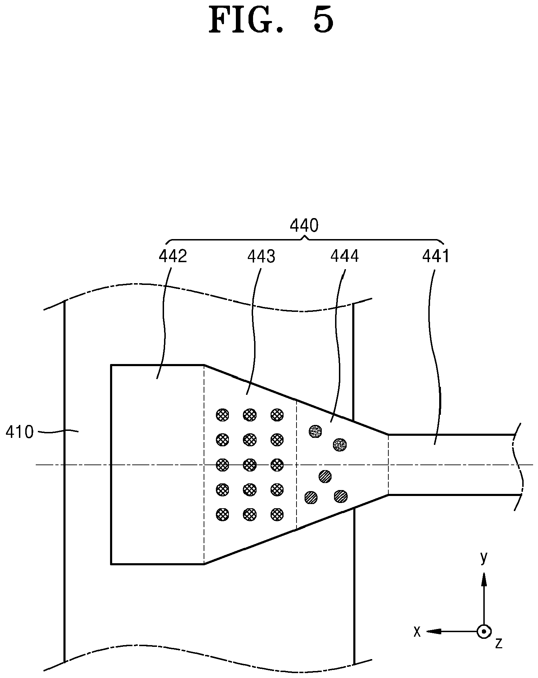

FIGS. 5 to 9 are schematic plan views of the mask assembly 400 according to other embodiments. The mask assembly 400 described below may be similar to the mask assembly 400 described above, and thus, differences are mainly described below.

Referring to FIG. 5, there is a difference from the support stick 440 described above in a shape of ends (or both ends) of the support stick 440. Widths of the correction welding portion 444 and the welding portion 443 may have a same taper angle. A width of the clamping portion 442 may have a constant value without being tapered. Even in this case, as described above, as areas of the welding portion 443 and the correction welding portion 444 are sufficiently secured, the degree of bending of the support stick 440 may be readily corrected.

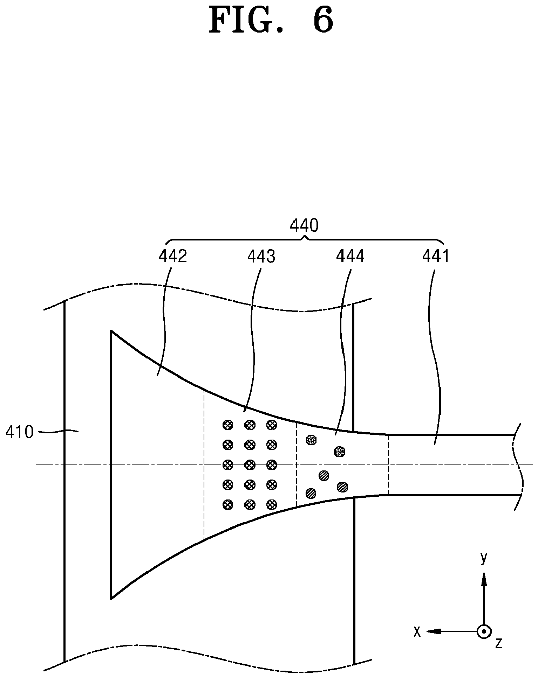

Referring to FIG. 6, in an embodiment, the correction welding portion 444, the welding portion 443, and the clamping portion 442 may be integral with one another and may have sides symmetrical to each other with respect to a center line of the width and be concavely tapered. For example, the correction welding portion 444, the welding portion 443, and the clamping portion 442 may have a same radius of curvature. Even in this case, as described above, as areas of the welding portion 443 and the correction welding portion 444 are sufficiently secured, the support stick 440 may be more firmly fixed on the mask frame 410, and the degree of bending of the support stick 440 may be readily corrected. The width of the correction welding portion 444 may gradually increase instead of rapidly increasing, and thus, the concentration of stress on a portion of the support stick 440 where the width rapidly changes may be prevented in case that the support stick 440 is tensioned. According to the embodiment, the clamping portion 442, welding portion 443, and correction welding portion 444 together may form cone.

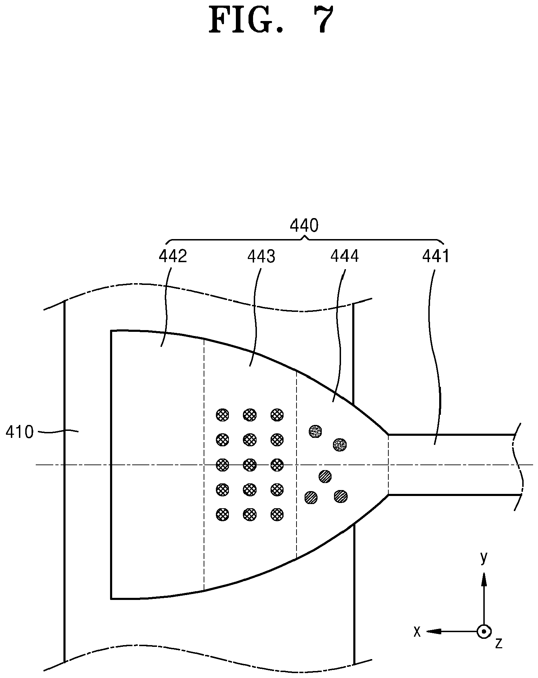

In another embodiment, as shown in FIG. 7, the correction welding portion 444, the welding portion 443, and the clamping portion 442 may be integral with one another and may have sides (or both sides) symmetrical to each other with respect to a center line of the width and be convexly tapered. For example, the correction welding portion 444, the welding portion 443, and the clamping portion 442 may have a same radius of curvature as one another. Even in this case, as described above, as areas of the welding portion 443 and the correction welding portion 444 are sufficiently secured, the support stick 440 may be more firmly fixed on the mask frame 410, and the degree of bending of the support stick 440 may be readily corrected.

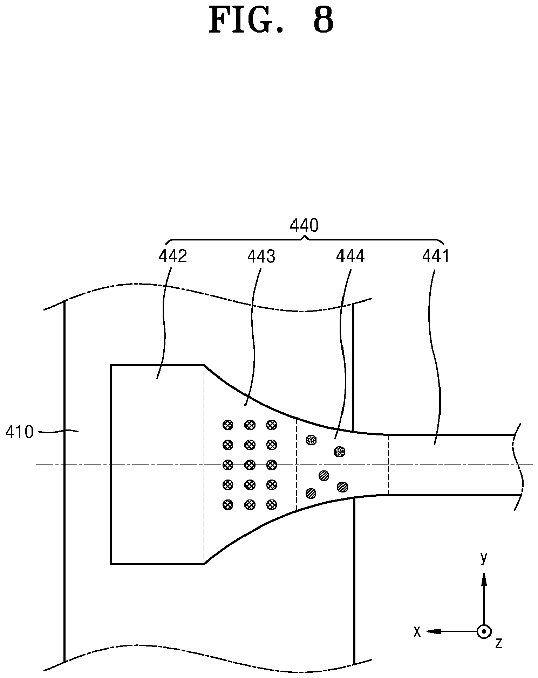

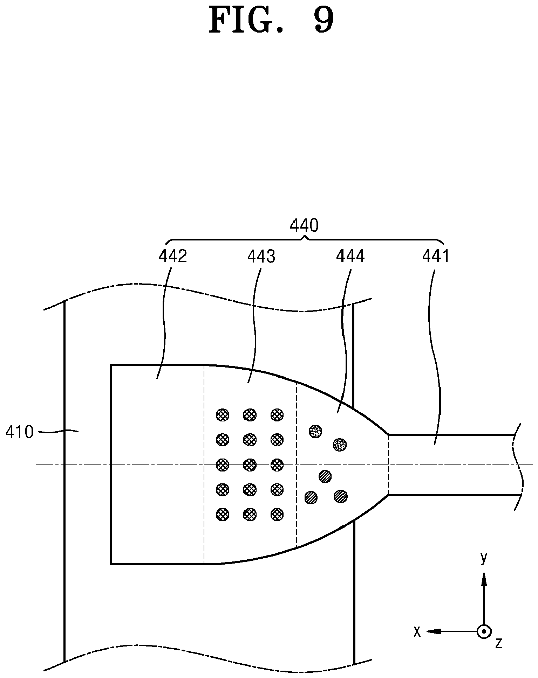

Referring to FIGS. 8 and 9, the correction welding portion 444 and the welding portion 443 may have sides (or both sides) symmetrical to each other with respect to a center line of the width and be concavely or convexly tapered, and a width of the clamping portion 442 may have a constant value without being tapered.

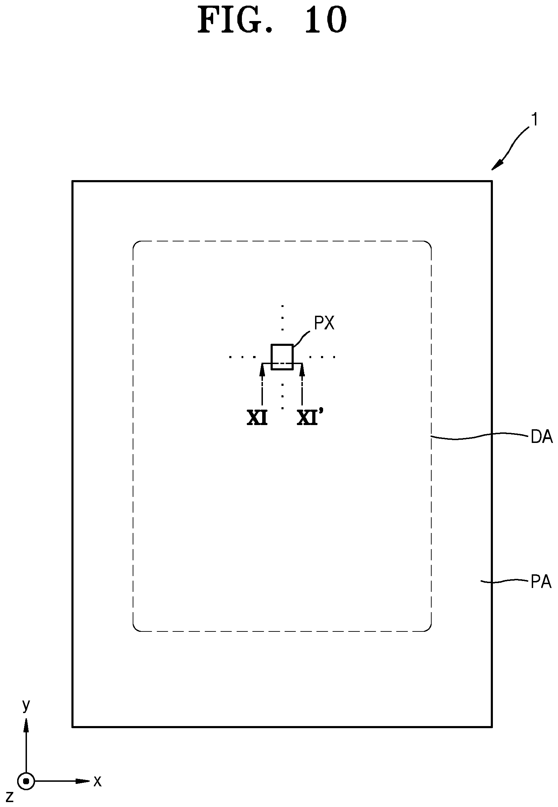

FIG. 10 is a schematic plan view of a display apparatus 1 manufactured using an apparatus for manufacturing a display apparatus, according to an embodiment.

Referring to FIG. 10, the display apparatus 1 manufactured according to an embodiment may include a display area DA and a peripheral area PA located outside the display area DA. The display apparatus 1 may provide an image through an array of pixels PX two-dimensionally arranged in the display area DA.

The peripheral area PA may be an area where an image is not provided, and may entirely or partially surround the display area DA. A driver for providing an electrical signal or power to a pixel circuit corresponding to each of the pixels PX may be arranged in the peripheral area PA. A pad, which is an area to which an electronic device or a printed circuit board may be electrically connected, may be arranged in the peripheral area PA.

Hereinafter, the display apparatus 1 including an organic light-emitting diode (OLED) as a light-emitting element will be described, but the display apparatus 1 according to one or more embodiments is not limited thereto. In another embodiment, the display apparatus 1 may be a light-emitting display including an inorganic light-emitting diode, for example, an inorganic light-emitting display. The inorganic light-emitting diode may include a p-n junction diode including inorganic semiconductor-based materials. In case that a voltage is applied to the p-n junction diode in a forward direction, holes and electrons may be injected, and light of a certain color may be emitted by converting energy generated by recombination of holes and electrons into light energy. The inorganic light-emitting diode described above may have a width of several to hundreds of micrometers, and in some embodiments, the inorganic light-emitting diode may be referred to as a micro-LED. In another embodiment, the display apparatus 1 may be a quantum dot light-emitting display.

The display apparatus 1 may be used as the display screen of not only portable electronic devices, such as a mobile phone, a smartphone, a tablet personal computer (PC), a mobile communication terminal, an electronic notebook, an e-book reader, a portable multimedia player (PMP), a navigation system, and an ultra-mobile PC (UMPC), but also various products, such as a television, a laptop computer, a monitor, a billboard, and an Internet of things (IoT) device. The display apparatus 1 according to an embodiment may be used in wearable devices, such as a smartwatch, a watch phone, a glasses-type display, and a head-mounted display (HMD). The display apparatus 1 according to an embodiment may be used as a car's dashboard, a center information display (CID) placed on a car's center fascia or dashboard, a room mirror display replacing a car's side-view mirror, or a display screen placed on the back of a front seat as entertainment for a car's rear seat.

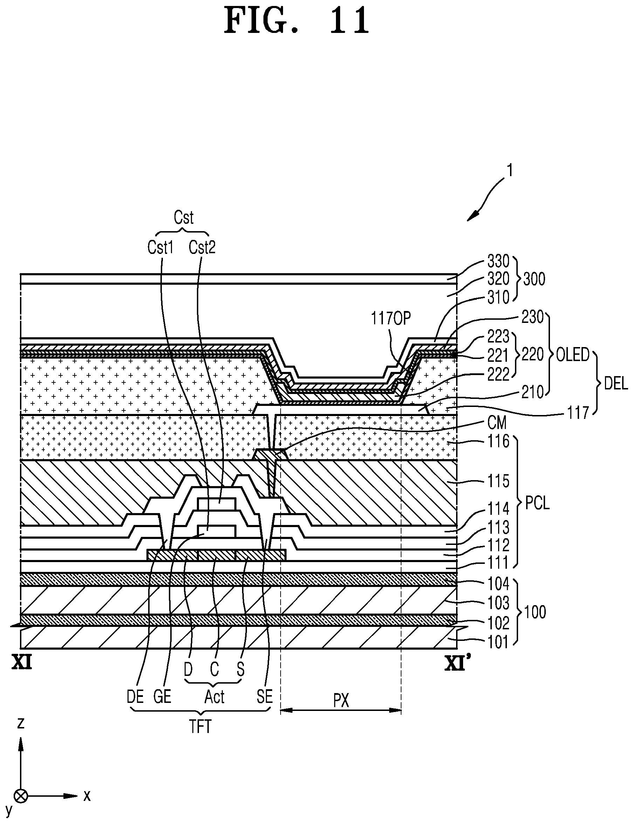

FIG. 11 is a schematic cross-sectional view of the display apparatus 1 manufactured by an apparatus for manufacturing a display apparatus, according to an embodiment, and may correspond to a cross-section of the display apparatus 1 taken along line XI-XI' of FIG. 10.

Referring to FIG. 11, the display apparatus 1 may include a stacked structure of the substrate 100, a pixel circuit layer PCL, a display element layer DEL, and/or an encapsulation layer 300. The display substrate DS (refer to FIG. 1) described above may be the one being in the process of manufacturing the display apparatus 1, for example, the one in which at least one of the pixel circuit layer PCL, the display element layer DEL, and the encapsulation layer 300 is stacked on the substrate 100.

The substrate 100 may have a multi-layer structure including a base layer and an inorganic layer, and the base layer may include polymer resin. For example, the substrate 100 may include a base layer including polymer resin, and a barrier layer of an inorganic insulating layer. For example, the substrate 100 may include a first base layer 101, a first barrier layer 102, a second base layer 103, and a second barrier layer 104 that are sequentially stacked on one another. The first base layer 101 and the second base layer 103 may include, e.g., polyimide (PI), polyethersulfone (PES), polyarylate, polyetherimide (PEI), polyethylene naphthalate (PEN), polyethylene terephthalate (PET), polyphenylene sulfide (PPS), polycarbonate (PC), cellulose triacetate (TAC), cellulose acetate propionate (CAP), or a combination thereof. The first barrier layer 102 and the second barrier layer 104 may include an inorganic insulating material, such as silicon oxide, silicon oxynitride, and/or silicon nitride. The substrate 100 may be flexible.

The pixel circuit layer PCL may be disposed on the substrate 100. FIG. 11 illustrates the pixel circuit layer PCL including a thin-film transistor TFT, and a buffer layer 111, a first gate insulating layer 112, a second gate insulating layer 113, an interlayer insulating layer 114, a first planarization insulating layer 115, and a second planarization insulating layer 116 disposed under and/or on elements of the thin-film transistor TFT.

The buffer layer 111 may reduce or prevent penetration of foreign materials, moisture, or external air from below the substrate 100 and may provide a flat surface on the substrate 100. The buffer layer 111 may include, e.g., an inorganic insulating material, such as silicon oxide, silicon oxynitride, and/or silicon nitride, and may have a single-layer or multi-layer structure including the above-described material.

The thin-film transistor TFT on the buffer layer 11 may include a semiconductor layer Act, and the semiconductor layer Act may include, e.g., polysilicon. As another example, the semiconductor layer Act may include, e.g., amorphous silicon, an oxide semiconductor, or an organic semiconductor. The semiconductor layer Act may include a channel region C, and a drain region D and a source region S respectively arranged on sides of the channel region C. A gate electrode GE may overlap the channel region C.

The gate electrode GE may include a low-resistance metal material. The gate electrode GE may include, e.g., a conductive material including molybdenum (Mo), aluminum (Al), copper (Cu), titanium (Ti), etc., or a combination thereof, and may have a multi-layer or single-layer structure including the above-described material.

The first gate insulating layer 112 between the semiconductor layer Act and the gate electrode GE may include an inorganic insulating material, such as silicon oxide (SiO₂), silicon nitride (SiNx), silicon oxynitride (SiON), aluminum oxide (Al₂O₃), titanium oxide (TiO₂), tantalum oxide (Ta₂O₅), hafnium oxide (HfO₂), zinc oxide (ZnOx), or a combination thereof. Zinc oxide (ZnOx) may be zinc oxide (ZnO) and/or zinc peroxide (ZnO₂).

The second gate insulating layer 113 may cover the gate electrode GE. Similar to the first gate insulating layer 112, the second gate insulating layer 113 may include an inorganic insulating material, such as silicon oxide (SiO₂), silicon nitride (SiNx), silicon oxynitride (SiON), aluminum oxide (Al₂O₃), titanium oxide (TiO₂), tantalum oxide (Ta₂O₅), hafnium oxide (HfO₂), zinc oxide (ZnOx), or a combination thereof. Zinc oxide (ZnOx) may be zinc oxide (ZnO) and/or zinc peroxide (ZnO₂).

A top electrode Cst2 of a storage capacitor Cst may be disposed on the second gate insulating layer 113. The top electrode Cst2 may overlap the gate electrode GE therebelow. The gate electrode GE and the top electrode Cst2 overlapping each other with the second gate insulating layer 113 therebetween may constitute the storage capacitor Cst. For example, the gate electrode GE may serve as a bottom electrode Cst1 of the storage capacitor Cst.

As described above, the storage capacitor Cst and the thin-film transistor TFT may overlap each other. In some embodiments, the storage capacitor Cst may not overlap the thin-film transistor TFT.

The top electrode Cst2 may include, e.g., aluminum (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), copper (Cu), or a combination thereof, and may have a single-layer or multi-layer structure including the above-described material.

The interlayer insulating layer 114 may cover the top electrode Cst2. The interlayer insulating layer 114 may include, e.g., silicon oxide (SiO₂), silicon nitride (SiNx), silicon oxynitride (SiON), aluminum oxide (Al₂O₃), titanium oxide (TiO₂), tantalum oxide (Ta₂O₅), hafnium oxide (HfO₂), zinc oxide (ZnOx), or a combination thereof. Zinc oxide (ZnOx) may be zinc oxide (ZnO) and/or zinc peroxide (ZnO₂). The interlayer insulating layer 114 may have a single-layer or multi-layer structure including the above-described inorganic insulating material.

A drain electrode DE and a source electrode SE may each be on the interlayer insulating layer 114. The drain electrode DE and the source electrode SE may be respectively connected to the drain region D and the source region S through contact holes formed in the insulating layers thereunder. The drain electrode DE and the source electrode SE may include a highly conductive material. The drain electrode DE and the source electrode SE may include a conductive material including molybdenum (Mo), aluminum (Al), copper (Cu), titanium (Ti), etc., and may have a multi-layer or single-layer structure including the above-described material. In an embodiment, the drain electrode DE and the source electrode SE may have a multi-layer structure of titanium (Ti)/aluminum (Al)/titanium (Ti).

The first planarization insulating layer 115 may cover the drain electrode DE and the source electrode SE. The first planarization insulating layer 115 may include an organic insulating material, such as a general commercial polymer, such as polymethylmethacrylate (PMMA) or polystyrene (PS), a polymer derivative having a phenol-based group, an acryl-based polymer, an imide-based polymer, an aryl ether-based polymer, an amide-based polymer, a fluorine-based polymer, a p-xylene-based polymer, a vinyl alcohol-based polymer, or a combination thereof.

The second planarization insulating layer 116 may be disposed on the first planarization insulating layer 115. The second planarization insulating layer 116 and the first planarization insulating layer 115 may include a same material, and the second planarization insulating layer 116 may include an organic insulating material, such as a general commercial polymer, such as PMMA or PS, a polymer derivative having a phenol-based group, an acryl-based polymer, an imide-based polymer, an aryl ether-based polymer, an amide-based polymer, a fluorine-based polymer, a p-xylene-based polymer, a vinyl alcohol-based polymer, and a blend thereof.

The display element layer DEL may be disposed on the pixel circuit layer PCL having the above-described structure. The display element layer DEL may include an organic light-emitting diode OLED as a display element (for example, a light-emitting element), and the organic light-emitting diode OLED may include a stacked structure of a pixel electrode 210, an intermediate layer 220, and a common electrode 230. The organic light-emitting diode OLED, for example, may emit red, green, or blue light, or may emit red, green, blue, or white light. The organic light-emitting diode OLED may emit light through an emission area, and the emission area may be defined as a pixel PX.

The pixel electrode 210 of the organic light-emitting diode OLED may be electrically connected to the thin-film transistor TFT through contact holes formed in the second planarization insulating layer 116 and the first planarization insulating layer 115 and a contact metal CM disposed on the first planarization insulating layer 115.

The pixel electrode 210 may include, e.g., conductive oxide, such as indium tin oxide (ITO), indium zinc oxide (IZO), zinc oxide (ZnO), indium oxide (In₂O₃), indium gallium oxide (IGO), aluminum zinc oxide (AZO), or a combination thereof. In another embodiment, the pixel electrode 210 may include, e.g., a reflective layer including silver (Ag), magnesium (Mg), aluminum (Al), platinum (Pt), palladium (Pd), gold (Au), nickel (Ni), neodymium (Nd), iridium (Ir), chromium (Cr), or a combination thereof. In another embodiment, the pixel electrode 210 may further include a layer formed of ITO, IZO, ZnO, or In₂O₃ on/under the above-described reflective layer.

A pixel-defining layer 117 including an opening 117OP exposing a central portion of the pixel electrode 210 may be disposed on the pixel electrode 210. The pixel-defining layer 117 may include an organic insulating material and/or an inorganic insulating material. The opening 117OP may define an emission area of light emitted from the organic light-emitting diode OLED. For example, a size or width of the opening 117OP may correspond to a size or width of the emission area. Accordingly, a size and/or width of the pixel PX may depend on a size and/or width of the corresponding opening 117OP of the pixel-defining layer 117.

The intermediate layer 220 may include an emission layer 222 corresponding to the pixel electrode 210. The emission layer 222 may include a high- or low-molecular weight organic material emitting light of a certain color. As another example, the emission layer 222 may include an inorganic light-emitting material or quantum dots.

In an embodiment, the intermediate layer 220 may include a first functional layer 221 and a second functional layer 223 respectively disposed under and on the emission layer 222. The first functional layer 221 may include, for example, a hole transport layer (HTL), or an HTL and a hole injection layer (HIL). The second functional layer 223 may be an element disposed on the emission layer 222, and may include an electron transport layer (ETL) and/or an electron injection layer (EIL). Similar to the common electrode 230 described below, the first functional layer 221 and/or the second functional layer 223 may be a common layer entirely covering the substrate 100.

The common electrode 230 may be disposed above the pixel electrode 210 and may overlap the pixel electrode 210. The common electrode 230 may include a conductive material having a low work function. For example, the common electrode 230 may include a (semi)transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or an alloy thereof. As another example, the common electrode 230 may further include a layer, such as ITO, IZO, ZnO, or In₂O₃, on a (semi)transparent layer including the above-described material. The common electrode 230 may be integrally formed to entirely cover the substrate 100.

The encapsulation layer 300 may be disposed on the display element layer DEL and may cover the display element layer DEL. The encapsulation layer 300 may include at least one inorganic encapsulation layer and at least one organic encapsulation layer, and as an embodiment, FIG. 11 illustrates the encapsulation layer 300 including a first inorganic encapsulation layer 310, an organic encapsulation layer 320, and a second inorganic encapsulation layer 330 that are sequentially stacked on one another.

The first inorganic encapsulation layer 310 and the second inorganic encapsulation layer 330 may include, e.g., one or more inorganic materials among aluminum oxide, titanium oxide, tantalum oxide, hafnium oxide, zinc oxide, silicon oxide, silicon nitride, and silicon oxynitride. The organic encapsulation layer 320 may include a polymer-based material. Examples of the polymer-based material may include acryl-based resin, epoxy-based resin, polyimide, and polyethylene. In an embodiment, the organic encapsulation layer 320 may include acrylate. The organic encapsulation layer 320 may be formed by curing a monomer or applying a polymer. The organic encapsulation layer 320 may have transparency.

Although not shown, a touch sensor layer may be disposed on the encapsulation layer 300, and an optical functional layer may be disposed on the touch sensor layer. The touch sensor layer may obtain an external input, for example, coordinate information according to a touch event. The optical functional layer may reduce the reflectivity of light (e.g., external light) incident on the display apparatus from the outside and/or may improve the color purity of light emitted from the display apparatus. In an embodiment, the optical functional layer may include a retarder and/or a polarizer. The retarder may be of a film type or a liquid crystal coating type and may include a λ/2 retarder and/or a λ/4 retarder. The polarizer may also be of a film type or a liquid crystal coating type. The film type may include a stretchable synthetic resin film, and the liquid crystal coating type may include liquid crystals arranged in a certain arrangement. The retarder and the polarizer may further include a protection film.

An adhesive member may be disposed between the touch sensor layer and the optical functional layer. As the adhesive member, a general one may be employed without limitation. The adhesive member may be a pressure-sensitive adhesive (PSA).

According to one or more embodiments, deposition quality of a deposition material may be improved by improving alignment of a mask assembly.

The above description is an example of technical features of the invention, and those skilled in the art to which the invention pertains will be able to make various modifications and variations. Thus, the embodiments of the invention described above may be implemented separately or in combination with each other.

Therefore, the embodiments disclosed in the invention are not intended to limit the technical scope of the invention, but to describe the technical scope of the invention

## Claims

1. A mask assembly (400) comprising:
a mask frame (410) comprising an opening area (OA);
a plurality of mask sheets (420) covering the opening area (OA) of the mask frame (410) and arranged side by side in a first direction; and
a support stick (440) arranged between the mask frame (410) and the plurality of mask sheets (420), extending in the first direction, and having ends fixed on the mask frame (410),
wherein widths of ends of the support stick (440) are greater than a width of a portion of the support stick (440) that overlaps the opening area (OA).

2. The mask assembly (400) of claim 1, wherein the widths of the ends of the support stick (440) are tapered such that the widths of the ends of the support stick (440) increase towards the ends of the support stick (440).

3. The mask assembly (400) of claim 1 or 2, wherein
the support stick (440) comprises:
a support portion (441) to support the plurality of mask sheets (420);
a clamping portion (442) arranged at a side of the support portion (441) and clamped to tension the support stick (440);
a welding portion (443) arranged between the support portion (441) and the clamping portion (442) and welded on the mask frame (410); and
a correction welding portion (444) arranged between the support portion (441) and the welding portion (443), and
widths of the correction welding portion (444) and the welding portion (443) are greater than a width of the support portion (441).

4. The mask assembly (400) of claim 3, wherein the correction welding portion (444), the welding portion (443), and the clamping portion (442) are tapered to each have a width that increases towards the ends of the support stick (440).

5. The mask assembly (400) of claim 3 or 4, wherein taper angles of the correction welding portion (444), the welding portion (443), and the clamping portion (442) are substantially equal to one another.

6. The mask assembly (400) of at least one of claims 3 to 5, wherein sides of the correction welding portion (444), the welding portion (443), and the clamping portion (442) are symmetrical with respect to a center line of the width and are concavely tapered.

7. The mask assembly (400) of at least one of claims 3 to 5, wherein sides of the correction welding portion (444), the welding portion (443), and the clamping portion (442) are symmetrical with respect to respective center lines of widths of the correction welding portion (444), the welding portion (443), and the clamping portion (442) and are convexly tapered.

8. The mask assembly (400) of at least one of claims 3 to 5, wherein
the correction welding portion (444) and the welding portion (443) are tapered to each have a width that increases towards the ends of the support stick (440), and
the clamping portion (442) has a constant width.

9. The mask assembly (400) of claim 3 or 4, wherein a width of a portion of the welding portion (443) that is connected to the clamping portion (442) is about 2 or more times and about 2.5 or less times the width of the support portion (441).

10. The mask assembly (400) of at least one of claims 1 to 9, further comprising:
a shield stick (430) extending in a second direction intersecting the first direction to shield a gap between the plurality of mask sheets (420).

11. An apparatus for manufacturing a display apparatus, the apparatus comprising:
a mask assembly (400) of at least one of claims 1 to 10 facing a display substrate (DS); and
a deposition source (50) facing the mask assembly (400) at a side opposite to the display substrate (DS).
